# EUROPEAN PATENT SPECIFICATION

(11) **EP 4 407 220 B1**
(45) Date of publication and mention of the grant of the patent: **28.01.2026**
(21) Application number: 22793833.9
(22) Date of filing: 07.09.2022
(51) Int. Cl.: F16K 37/00, F16K 31/04, G01R 31/28

(54) **METHOD AND DEVICE FOR MEASURING VALVE CHARACTERISTIC PARAMETERS**
VERFAHREN UND VORRICHTUNG ZUR MESSUNG VON VENTILKENNWERTEN
PROCÉDÉ ET DISPOSITIF DE MESURE DE PARAMÈTRES CARACTÉRISTIQUES DE SOUPAPE

(30) Priority: 24.09.2021 CN 202111124284
(43) Date of publication of application: 31.07.2024
(73) Proprietor: Siemens Schweiz AG, 8047 Zürich (CH)
(72) Inventor: CHEN, Zhi Min, Beijing 100085 (CN); FAN, Shun Jie, Beijing 100102 (CN); PAN, Cheng, Beijing 100044 (CN); ZHANG, Bin, Beijing 100029 (CN)
(74) Representative: Siemens Patent Attorneys
(86) International application number: PCT/IB2022/058422
(87) International publication number: WO 2023/052875

(56) References cited:
- CN-A- 112 728 195
- JP-A- H10 102 997
- US-A- 5 140 853
- US-A1- 2020 072 373
- US-A1- 2021 285 681

## Description

### TECHNICAL FIELD

The present invention in general relates to the field of valve controllers, and in particular to a valve actuator with a device for measuring valve characteristic parameters.

### BACKGROUND OF THE INVENTION

Valves are widely used in heating, ventilation, and air conditioning systems (HVAC), and a valve actuator controls the flow by controlling the position of a valve. Different valves have different sizes, stroke lengths, seal types, dead zone lengths, etc. In the prior art, a valve is controlled by a dedicated valve controller, and there is no need to measure the characteristic parameters of the valve (stroke length, dead zone length, etc.). Valve controls of different types or even with different characteristic parameters cannot be used interchangeably. Some manufacturers use mechanical means such as flaps to increase the versatility of valve actuators, but there is still a huge limitation.

US 5 140 853 A discloses an apparatus for monitoring of actual valve stern thrust loads in a motor operated valve. The thrust loads are measured directly by the use of load cells disposed directly between the valve and the operator. Direct measurement of stern thrust eliminates the errors associated with indirect methods. Analysis of actual thrust load measurements and correlation with other operating parameters, such as switch actuation and motor current, provides the capability to accurately calibrate valve operators and to detect valve and operator problems at an early stage.

As disclosed in JP H10 102997 A, a proportional flow control solenoid valve for large flow, for controlling the flow rate of pressure oil supplied to a pressing jack, and a servo valve for small flow are connected in parallel between a hydraulic pump and the pressing jack. When the measurement of a stroke sensor shows that the pressing jack has reached a stroke position ahead of a target stroke position, a controlling computing part calculates a valve command value such that the proportional flow control solenoid valve is closed, then outputs a control signal corresponding to the valve command value to the proportional flow control solenoid valve and, when the pressing jack has reached the target stroke position, calculates a valve command value such that the servo valve is closed, and outputs a control signal corresponding to the valve command value to the servo valve.

US 2020/072373 A1 discloses a pressure disturbance rejection valve assembly. The valve assembly includes a valve, a flow rate sensor, and an actuator. The actuator includes a motor, a drive device configured to be driven by the motor and coupled to the valve for driving the valve within a range of positions, and a position sensor configured to measure a rotational position of the drive device. The actuator further includes a communications mechanism configured to receive a flow rate setpoint and a processing circuit. The processing circuit is configured to determine an actuator position setpoint using a feedback control mechanism based on the flow rate setpoint and the flow rate measurement, operate the motor to drive the drive device to the actuator position setpoint, detect a fault condition based at least in part on the rotational position measurement or the flow rate measurement, and perform a fault mitigation action in response to detection of the fault condition.

US 2021/285681 A1 discloses an assembly including a thermoelectric tripping device, a flange, and a gland. The thermoelectric tripping device is configured to be detachably coupled with a damper. The thermoelectric tripping device includes an extending arm including a fuse configured to trip at a pre-defined temperature.

CN 112728195 A discloses a torque and stroke measuring system for an electric valve and an actuator thereof. The system comprises the electric valve actuator, a fiber bragg grating sensor, an optical signal rotary coupling assembly and an upper computer. The electric valve actuator comprises a worm and a worm gear, and an output shaft of the worm gear is connected with a valve rod of the to-be-measured valve. The fiber bragg grating sensor is buried into the outer peripheral surface of the worm in the axis direction of the worm, so that the central wavelength of the fiber bragg grating sensor periodically changes along with the rotation of the worm.

### BRIEF SUMMARY OF THE INVENTION

To solve the above technical problem, the present invention provides a valve actuator with a device for measuring valve characteristic parameters according to claim 1, so as to improve the versatility of valve actuators.

The present invention provides a valve actuator with a device for measuring valve characteristic parameters of the valve actuator, wherein the valve characteristic parameters comprise a stroke length of the valve, the valve actuator is used to drive the valve and comprises a push rod driven by a motor, the push rod is adapted to push a valve rod of the valve, and the motor is connected to a current sensor, which is adapted to measure a DC drive current flowing into the motor, and the measuring device comprises: a resetting module, which resets the push rod to a top end position; a first recording module, which, when the push rod is driven to push the valve rod and the DC drive current is measured in real time, records a first position of the push rod at the start of a first abrupt change in the DC drive current when the first abrupt change in the DC drive current is detected and lasts for more than a first preset time period; a second recording module, which, when the push rod continues to be driven to push the valve rod and the DC drive current continues to be measured in real time, records a second position of the push rod at the start of a second abrupt change in the DC drive current when the second abrupt change in the DC drive current is detected and lasts for more than a second preset time period; a calculating module, which calculates the stroke length of the valve based on the first position and the second position.

Preferably, the valve characteristic parameters further comprise a dead zone length, and the measuring device further comprises: when the push rod continues to be driven to push the valve rod and an output driving force of the motor is measured in real time, recording a third position of the push rod when the output driving force reaches a preset output force, and calculating the dead zone length of the valve based on the second position and the third position.

Preferably, the valve actuator also has a position sensor, which is used to detect the drive shaft position of the motor, and the measuring device comprises: measuring the drive shaft position of the motor by the position sensor, and converting the drive shaft position to a position of the push rod.

Preferably, the measuring device comprises: measuring the DC drive current in real time, calculating an average change rate of the DC drive current, and identifying the first abrupt change and/or the second abrupt change in the DC drive current when an instantaneous change rate is greater than the average change rate.

Preferably, the measuring device comprises: repeating the functions of the measuring device a plurality of times, and taking the measurement result as a characteristic parameter of the valve when the results of the plurality of times of measurement by the measuring device are consistent.

### BRIEF DESCRIPTION OF THE DRAWINGS

The following drawings are only intended to illustrate and explain the present invention schematically, and do not limit the scope of the present invention. In the drawings,
Figure 1 is a flowchart of a measuring method;
Figure 2 is a schematic diagram of a valve actuator and a valve according to one embodiment of the present invention;
Figure 3 is a schematic diagram of the DC drive current;
Figure 4 is a schematic diagram of a measuring device;
Figure 5 is a schematic diagram of an electronic device.

### Reference signs in the drawings

100 Measuring method
110-140 Steps
210 Valve actuator
211 Power supply
212 Current sensor
213 Motor
214 Position sensor
215 Processing unit
216 Speed change mechanism
217 Push rod
220 Valve
221 Valve rod
D Valve closing direction
P1 First position
P2 Second position
400 Measuring module
410 Resetting module
420 First recording module
430 Second recording module
440 Calculating module
500 Electronic device
510 Processor
520 Memory

### DETAILED DESCRIPTION OF THE EMBODIMENTS

In order to have a clearer understanding of the technical features, purpose and effects of the present invention, the specific embodiments of the present invention will be described below with reference to the drawings.

In the following description, many specific details are provided in order to fully understand the present invention. However, the present invention may also be implemented in other ways different from those described herein. Therefore, the present invention is not limited to the specific embodiments disclosed below but it shall encompass the content of the appended claims.

As shown in this patent application and the claims, unless the context clearly dictates otherwise, terms "a", "an", "one" and/or "the" are not intended to be specific in the singular and may include the plural. Generally, terms "comprising" and "including" only imply that the clearly identified steps and elements are included, these steps and elements do not constitute an exclusive list, and the method or device may also include other steps or elements.

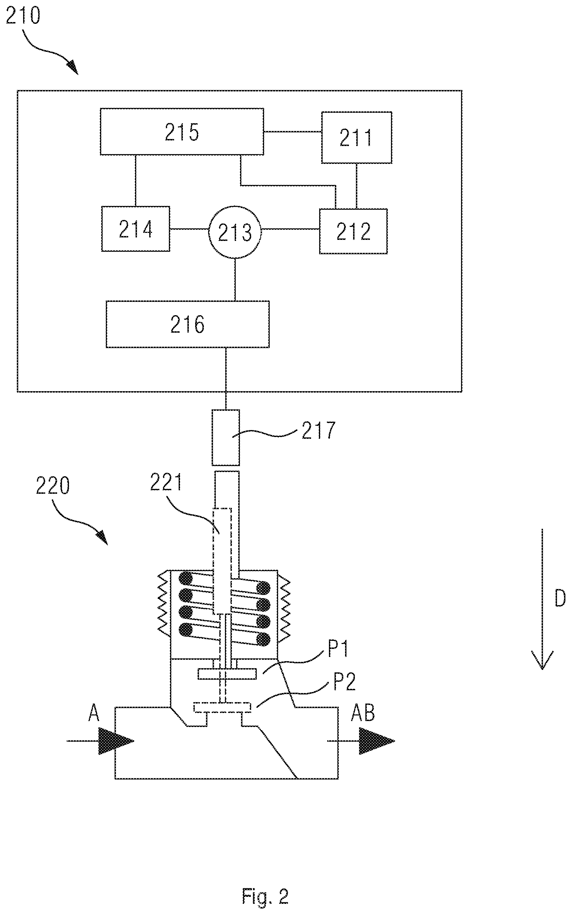

Figure 2 is a schematic diagram of a valve actuator 210 and a valve 220 according to one embodiment of the present invention. The valve actuator 210 is used to drive the valve 220. The valve 220 may be a normally open valve, which is normally open by default, i.e., in the fully open position, and the valve 220 is partially opened or closed under the drive of the valve actuator 210. The valve 220 may also be a normally closed valve, which is normally closed by default, i.e., in the fully closed position, and the valve 220 is partially or fully opened under the drive of the valve actuator 210. To simplify the description, a normally open valve will be used as an example below.

The valve actuator 210 comprises a power supply 211, a current sensor 212, a motor 213, a position sensor 214, a processing unit 215, a speed change mechanism 216 and a push rod 217. The power supply 211 is used to supply power to the motor 213, and the current sensor 212 is arranged on the circuit between the power supply 211 and the motor 213. For this purpose, the current sensor 212 is adapted to measure the DC drive current flowing into the motor 213. The motor 213 may be an integrated motor, i.e., integrated with the actuator, which can reduce the volume and cost of the motor 213. The position sensor 214 is connected to the motor 213 and the processing unit 215, and is adapted to measure the drive shaft position of the motor 213 and send the drive shaft position to the processing unit 215. The processing unit 215 is connected to the current sensor 212 and the position sensor 214, to receive and process the data sent by the current sensor 212 and the position sensor 214. The motor 213, the speed change mechanism 216 and the push rod 217 are connected in sequence, so that the push rod 217 can move under the drive of the motor 213. The push rod 217 is adapted to push the valve rod 221 of the valve 220.

The valve 220 is used to enable, disable or regulate the flow of fluid in a pipeline. The valve comprises a push rod 221 which is adapted to move in the closing direction D. The valve 220 is fully opened when the valve rod 221 is at the top end position P1, and the valve 220 is closed when the valve rod 221 moves along the closing direction D to contact the bottom end position P2. The distance between the top end position P1 and the bottom end position P2 is the stroke length of the valve 220. For elastic materials, the valve rod 221 can continue to move from the position where it is in contact with the bottom end position P2 to the stop position P3 (not shown in the figure). The distance between the bottom end position P2 and the stop position P3 is the dead zone length of the valve 220. Different types of valves 220 usually have different stroke lengths and dead zone lengths, and valves of different types or even different characteristic parameters cannot be used interchangeably. The embodiments of the present invention make it possible to use the actuator in different types of valves by measuring the stroke length and dead zone length of the valve.

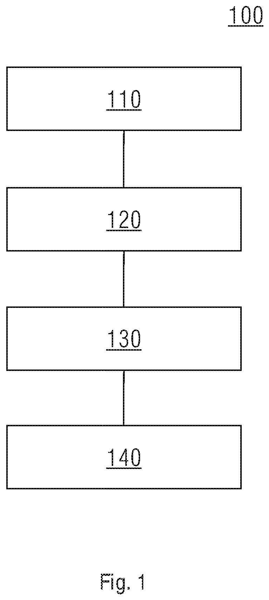

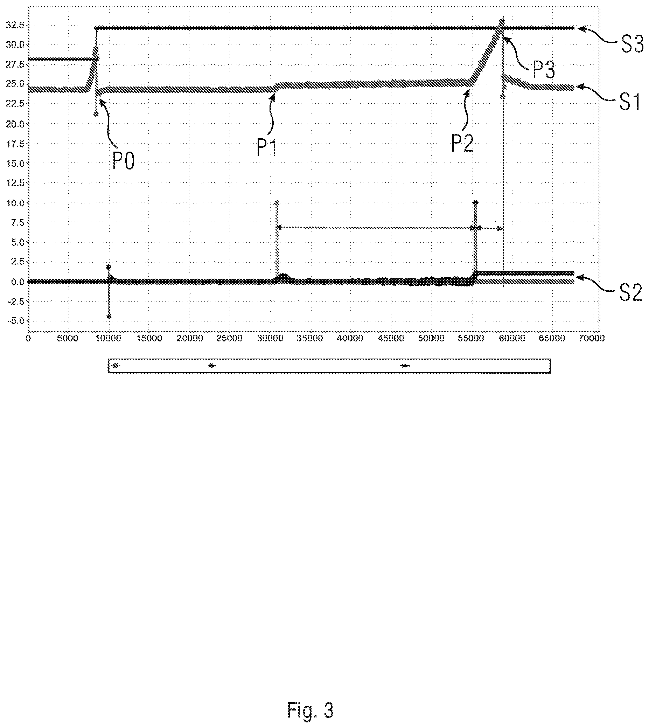

Figure 1 is a flowchart of a measuring method 100. As shown in Figure 1, the measuring method comprises:
Step 110, resetting the push rod to a top end position. The push rod 217 is probably not in the top end position initially, and is reset to the top end position. When the push rod 217 reaches the top end position from a middle position, the DC drive current detected by the current sensor 212 will change abruptly. By detecting an abrupt change in the DC drive current, it can be determined that the push rod 217 has reached the top end position. Figure 3 is a schematic diagram of the DC drive current according to one embodiment of the present invention, wherein the abscissa is the time, in milliseconds (ms), and the ordinate is the DC drive current, in milliamperes (mA). S1 is the curve of the DC drive current, and S2 is the curve of the rate of change of the DC drive current. As shown in Figure 3, when the push rod 217 reaches the top end position P0, the DC drive current curve S1 suddenly rises, which is also reflected in the change rate curve S2 of the DC drive current.
Step 120, driving the push rod to push the valve rod, measuring the DC drive current in real time, and recording a first position of the push rod at the start of a first abrupt change in the DC drive current when the first abrupt change in the DC drive current is detected and lasts for more than a first preset time period.

The push rod 217 is driven to move toward the closing direction D of the valve 220, and the DC drive current is measured in real time. As shown in Figure 3, when the DC drive current has the first abrupt change that lasts for more than the first preset time period, the position of the push rod at the start of the first abrupt change in the DC drive current is where the push rod 217 and the valve rod 221 start to contact, i.e., the valve rod 221 is in the top end position, until the push rod 217 is fully joined with the valve rod 221, and the first position VP1 of the push rod at the start of the first abrupt change in the DC drive current is recorded. In some embodiments, the position sensor 214 can detect the drive shaft position of the motor 213 and convert the drive shaft position into the first position VP1 of the push rod 217. In some embodiments, by measuring the DC drive current in real time and calculating the average rate of change (for example, the root mean square) of the DC drive current, the first abrupt change in the first DC drive current is identified when the instantaneous rate of change is greater than the average rate of change.

Step 130, continuing to drive the push rod to push the valve rod and measure the DC drive current in real time, and recording a second position of the push rod at the start of a second abrupt change in the DC drive current when the second abrupt change in the DC drive current is detected and lasts for more than a second preset time period.

The push rod 217 continues to be driven to move toward the closing direction D of the valve 220, and the DC drive current is measured in real time. As shown in Figure 3, when the DC drive current has the second abrupt change that lasts for more than the second preset time period, the position of the push rod at the start of the second abrupt change in the DC drive current is where the valve rod 221 comes into contact with the bottom end position, and the second position VP2 of the push rod at the start of the second abrupt change in the DC drive current is recorded. In some embodiments, the position sensor can detect the drive shaft position of the motor and convert the drive shaft position into the position of the push rod. In some embodiments, the position sensor 214 can detect the drive shaft position of the motor 213 and convert the drive shaft position into the second position VP2 of the push rod 217. In some embodiments, by measuring the DC drive current in real time and calculating the average rate of change (for example, the root mean square) of the DC drive current, the second abrupt change in the first DC drive current is identified when the instantaneous rate of change is greater than the average rate of change.

Step 140, calculating the stroke length of the valve based on the first position and the second position.

The first position VP1 is the position where the push rod 217 and the valve rod 221 start to contact, i.e., the valve rod 221 is in the top end position, and the second position VP2 is the position where the valve rod 221 contacts the bottom end position. The stroke length of the valve can be calculated by subtracting the first position VP1 from the second position VP2.

In some embodiments, the valve characteristic parameters further comprise a dead zone length, and the measuring method further comprises: continuing to drive the push rod to push the valve rod and measure an output driving force of the motor in real time, recording a third position of the push rod when the output driving force reaches a preset output force, and calculating the dead zone length of the valve based on the second position and the third position. Based on the required force for fully closing the valve, the valve is deemed to be tightly closed when the output driving force reaches a preset output force.

Specifically, the push rod 217 continues to be driven to move in the closing direction D of the valve 220, and the DC drive current is measured in real time. As shown in Figure 3, when the output driving force reaches the preset output force, the position of the push rod is where the valve rod 221 stops, and the third position VP3 of the push rod is recorded. The third position VP3 is where the valve rod 221 reaches the stop position. The dead zone length of the valve can be calculated by subtracting the second position VP2 from the third position VP3. In some embodiments, the position sensor can detect the drive shaft position of the motor and convert the drive shaft position into the position of the push rod. In some embodiments, the position sensor 214 can detect the drive shaft position of the motor 213 and convert the drive shaft position into the third position VP3 of the push rod 217.

In some embodiments, the measuring method comprises: repeating the measuring method a plurality of times, and taking the measurement result as a characteristic parameter of the valve when the results of the plurality of times of measurement in the measuring method are consistent. This can improve the accuracy of the measurement result.

The table below shows the measurement results using the measuring method. It can be seen that the measuring method is very accurate.

| Type of valve | Rated stroke length | VP1 (mm) | VP2 (mm) | Stroke length (mm) | VP3 (mm) | Dead zone length (mm) |
|---|---|---|---|---|---|---|
| VVP46 .20F1.4 | 4.5mm | 1.810 | 6.399 | 4.589 | 6.845 | 0.445 |
| | | 1.845 | 6.401 | 4.557 | 6.852 | 0.451 |
| | | 1.846 | 6.403 | 4.558 | 6.860 | 0.456 |
| | | 1.858 | 6.404 | 4.547 | 6.866 | 0.462 |
| | | 1.850 | 6.403 | 4.553 | 6.860 | 0.456 |
| VXI46 .25/2 | 2.5mm | 2.194 | 4.703 | 2.509 | 4.933 | 0.230 |
| | | 2.193 | 4.707 | 2.514 | 4.923 | 0.216 |
| | | 2.199 | 4.706 | 2.506 | 4.932 | 0.226 |
| | | 2.205 | 4.708 | 2.503 | 4.933 | 0.225 |
| | | 2.198 | 4.707 | 2.509 | 4.930 | 0.223 |

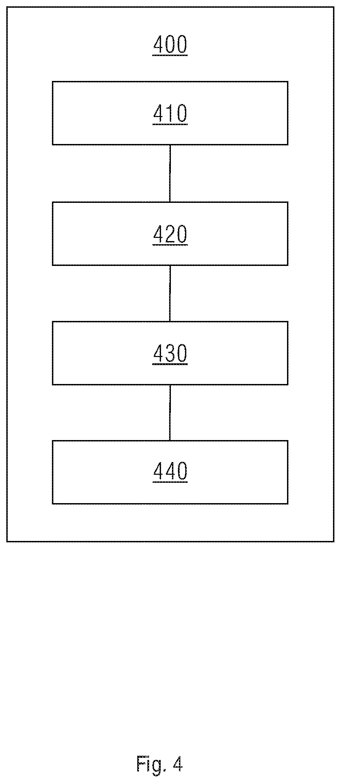

Figure 4 is a schematic diagram of a measuring device 400. As shown in Figure 4, the measuring device 400 comprises:
a resetting module 410, which resets the push rod to a top end position;
a first recording module 420, which, when the push rod is driven to push the valve rod and the DC drive current is measured in real time, records a first position of the push rod at the start of a first abrupt change in the DC drive current when the first abrupt change in the DC drive current is detected and lasts for more than a first preset time period;
a second recording module 430, which, when the push rod continues to be driven to push the valve rod and the DC drive current continues to be measured in real time, records a second position of the push rod at the start of a second abrupt change in the DC drive current when the second abrupt change in the DC drive current is detected and lasts for more than a second preset time period; and
a calculating module 440, which calculates the stroke length of the valve based on the first position and the second position.

In some embodiments, the valve characteristic parameters further comprise a dead zone length, and the measuring device further comprises: continuing to drive the push rod to push the valve rod and measure an output driving force of the motor in real time, recording a third position of the push rod when the output driving force reaches a preset output force, and calculating the dead zone length of the valve based on the second position and the third position.

In some embodiments, the valve actuator also has a position sensor, which is used to detect the drive shaft position of the motor, and the measuring device comprises: measuring the drive shaft position of the motor by the position sensor, and converting the drive shaft position to a position of the push rod.

In some embodiments, the measuring device comprises: measuring the DC drive current in real time, calculating the average rate of change of the DC drive current, and identifying the first and/or the second abrupt change in the first DC drive current when the instantaneous rate of change is greater than the average rate of change.

In some embodiments, the measuring device comprises: repeating the measuring method a plurality of times, and taking the measurement result as a characteristic parameter of the valve when the results of the plurality of times of measurement in the measuring method are consistent.

The present invention also provides a valve actuator, which has a measuring device 400 as described above.

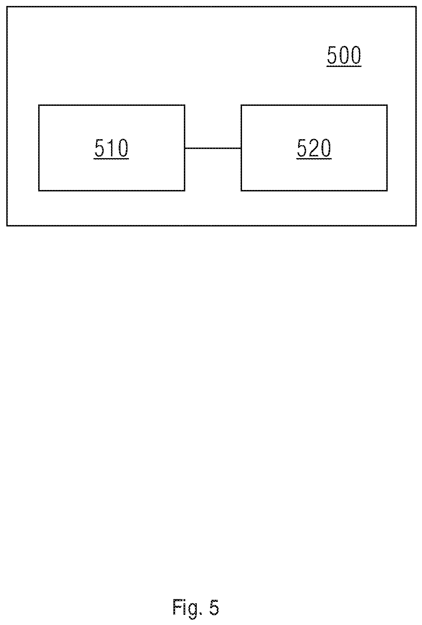

Figure 5 is a schematic diagram of an electronic device 500. As shown in Figure 5, the electronic device 500 comprises a processor 510 and a memory 520, with an instruction stored in the memory 520, wherein the instruction, when executed by the processor 510, implements the method 100 as described above.

Some aspects of the device of the present invention may be implemented entirely by hardware or entirely by software (including firmware, resident software, microcode, etc.), or by a combination thereof. The above hardware or software may be referred to as a "data block", "module", "engine", "unit", "component" or "system". The processor may be one or more application specific integrated circuits (ASICs), digital signal processors (DSPs), digital signal processing devices (DAPDs), programmable logic devices (PLDs), field programmable gate arrays (FPGAs), processors, controllers, microcontrollers, microprocessors, or a combination thereof.

## Claims

1. A valve actuator, wherein the valve actuator has a measuring device (400) for measuring valve characteristic parameters of the valve actuator, wherein the valve characteristic parameters comprise a stroke length of the valve, the valve actuator is used to drive the valve and comprises a push rod driven by a motor, the push rod is adapted to push a valve rod of the valve, and the motor is connected to a current sensor, which is adapted to measure a DC drive current of the motor, wherein the measuring device (400) comprises:
- a resetting module (410), which resets the push rod to a top end position;
- a first recording module (420), which, when the push rod is driven to push the valve rod and the DC drive current is measured in real time, records a first position of the push rod at the start of a first abrupt change in the DC drive current when the first abrupt change in the DC drive current is detected and lasts for more than a first preset time period;
- a second recording module (430), which, when the push rod continues to be driven to push the valve rod and the DC drive current continues to be measured in real time, records a second position of the push rod at the start of a second abrupt change in the DC drive current when the second abrupt change in the DC drive current is detected and lasts for more than a second preset time period; and
- a calculating module (440), which calculates the stroke length of the valve based on the first position and the second position.

2. The valve actuator as claimed in claim 1, wherein the valve characteristic parameters further comprise a dead zone length, and the measuring device (400) further comprises: when the push rod continues to be driven to push the valve rod and an output driving force of the motor is measured in real time, recording a third position of the push rod when the output driving force reaches a preset output force, and calculating the dead zone length of the valve based on the second position and the third position.

3. The valve actuator as claimed in claim 1 or 2, wherein the valve actuator also has a position sensor, which is used to detect the drive shaft position of the motor, and the measuring device (400) comprises: measuring the drive shaft position of the motor by the position sensor, and converting the drive shaft position to a position of the push rod.

4. The valve actuator as claimed in claim 1 or 2, wherein the measuring device (400) comprises: measuring the DC drive current in real time, calculating an average change rate of the DC drive current, and identifying the first abrupt change and/or the second abrupt change in the DC drive current when an instantaneous change rate is greater than the average change rate.

5. The valve actuator as claimed in claim 1 or 2, wherein the measuring device (400) comprises: repeating the functions of the measuring device (400) a plurality of times, and taking the measurement result as a characteristic parameter of the valve when the results of the plurality of times of measurement by the measuring device (400) are consistent.

## Patentansprüche

1. Ventilantrieb, wobei der Ventilantrieb eine Messvorrichtung (400) zum Messen von Ventilkennwerten des Ventilantriebs aufweist, wobei die Ventilkennwerte die Hublänge des Ventils umfassen, der Ventilantrieb zum Antreiben des Ventils dient und eine von einem Motor angetriebene Schubstange umfasst, die zum Bewegen einer Ventilstange des Ventils ausgelegt ist, und der Motor mit einem Stromsensor verbunden ist, der den Gleichstrom des Motors misst, wobei die Messvorrichtung (400) Folgendes umfasst:
- ein Rückstellmodul (410), das die Schubstange in eine obere Endposition zurückstellt;
- ein erstes Aufzeichnungsmodul (420), das, wenn die Schubstange angetrieben wird, um die Ventilstange zu schieben, und der Gleichstromantriebsstrom in Echtzeit gemessen wird, eine erste Position der Schubstange zu Beginn einer ersten abrupten Änderung des Gleichstromantriebsstroms aufzeichnet, wenn die erste abrupte Änderung des Gleichstromantriebsstroms erkannt wird und länger als eine erste voreingestellte Zeitspanne anhält;
- ein zweites Aufzeichnungsmodul (430), das, wenn die Schubstange weiterhin angetrieben wird, um die Ventilstange zu schieben, und der Gleichstromantriebsstrom weiterhin in Echtzeit gemessen wird, eine zweite Position der Schubstange zu Beginn einer zweiten abrupten Änderung des Gleichstromantriebsstroms aufzeichnet, wenn die zweite abrupte Änderung des Gleichstromantriebsstroms erkannt wird und länger als eine zweite voreingestellte Zeitspanne anhält; und
- ein Berechnungsmodul (440), das die Hublänge des Ventils auf Grundlage der ersten Position und der zweiten Position berechnet.

2. Ventilantrieb wie in Anspruch 1 beansprucht, wobei die Ventilkennwerte ferner eine Totzonenlänge umfassen und die Messvorrichtung (400) ferner Folgendes umfasst: wenn die Schubstange weiterhin angetrieben wird, um die Ventilstange zu schieben, und eine Ausgangsantriebskraft des Motors in Echtzeit gemessen wird, Aufzeichnen einer dritten Position der Schubstange, wenn die Ausgangsantriebskraft eine voreingestellte Ausgangskraft erreicht, und Berechnen der Totzonenlänge des Ventils auf Grundlage der zweiten Position und der dritten Position berechnet.

3. Ventilantrieb wie in Anspruch 1 oder 2 beansprucht, wobei der Ventilantrieb auch einen Positionssensor aufweist, der verwendet wird, um die Antriebswellenposition des Motors zu berechnen, und die Messvorrichtung (400) Folgendes umfasst: Messen der Antriebswellenposition des Motors mit dem Positionssensor und Umwandeln der Antriebswellenposition in eine Position der Schubstange.

4. Ventilantrieb wie in Anspruch 1 oder 2 beansprucht, wobei die Messvorrichtung (400) Folgendes umfasst: Messen des Gleichstromantriebsstroms in Echtzeit, Berechnen einer durchschnittlichen Änderungsrate des Gleichstromantriebsstroms und Erkennen der ersten abrupten Änderung und/oder der zweiten abrupten Änderung des Gleichstromantriebsstroms, wenn eine momentane Änderungsrate größer ist als die durchschnittliche Änderungsrate.

5. Der Ventilantrieb nach Anspruch 1 oder 2, wobei die Messvorrichtung (400) Folgendes umfasst: Wiederholen der Funktionen der Messvorrichtung (400) eine Vielzahl von Malen und Verwenden des Messergebnisses als Kennwert des Ventils, wenn die Ergebnisse der Vielzahl von Malen des Messens durch die Messvorrichtung (400) gleichbleibend sind.

## Revendications

1. Actionneur de soupape, dans lequel l'actionneur de soupape comporte un dispositif de mesure (400) pour mesurer des paramètres caractéristiques de soupape de l'actionneur de soupape, dans lequel les paramètres caractéristiques de soupape comprennent une longueur de course de la soupape, l'actionneur de soupape est utilisé pour entraîner la soupape et comprend une tige de poussée qui est entraînée par un moteur, la tige de poussée est adaptée pour pousser une tige de soupape de la soupape, et le moteur est connecté à un capteur de courant, lequel est adapté pour mesurer un courant d'entraînement du type courant continu/DC du moteur, dans lequel le dispositif de mesure (400) comprend :
- un module de réinitialisation (410), lequel réinitialise la tige de poussée selon une position d'extrémité sommitale ;
- un premier module d'enregistrement (420), lequel, lorsque la tige de poussée est entraînée pour pousser la tige de soupape et que le courant d'entraînement DC est mesuré en temps réel, enregistre une première position de la tige de poussée au début d'une première variation brutale du courant d'entraînement DC lorsque la première variation brutale du courant d'entraînement DC est détectée et qu'elle dure pendant plus qu'une première période temporelle prédéfinie ;
- un second module d'enregistrement (430), lequel, lorsque la tige de poussée continue à être entraînée pour pousser la tige de soupape et que le courant d'entraînement DC continue à être mesuré en temps réel, enregistre une deuxième position de la tige de poussée au début d'une seconde variation brutale du courant d'entraînement DC lorsque la seconde variation brutale du courant d'entraînement DC est détectée et qu'elle dure pendant plus qu'une seconde période temporelle prédéfinie ; et
- un module de calcul (440), lequel calcule la longueur de course de la soupape sur la base de la première position et de la deuxième position.

2. Actionneur de soupape selon la revendication 1, dans lequel les paramètres caractéristiques de soupape comprennent en outre une longueur de zone morte, et le dispositif de mesure (400) comprend en outre : lorsque la tige de poussée continue à être entraînée pour pousser la tige de soupape et qu'une force d'entraînement de sortie du moteur est mesurée en temps réel, l'enregistrement d'une troisième position de la tige de poussée lorsque la force d'entraînement de sortie atteint une force de sortie prédéfinie, et le calcul de la longueur de zone morte de la soupape sur la base de la deuxième position et de la troisième position.

3. Actionneur de soupape selon la revendication 1 ou 2, dans lequel l'actionneur de soupape comporte également un capteur de position, lequel est utilisé pour détecter la position d'arbre d'entraînement du moteur, et le dispositif de mesure (400) comprend : la mesure de la position d'arbre d'entraînement du moteur au moyen du capteur de position, et la conversion de la position d'arbre d'entraînement selon une position de la tige de poussée.

4. Actionneur de soupape selon la revendication 1 ou 2, dans lequel le dispositif de mesure (400) comprend : la mesure du courant d'entraînement DC en temps réel, le calcul d'un taux de variation moyen du courant d'entraînement DC et l'identification de la première variation brutale et/ou de la seconde variation brutale du courant d'entraînement DC lorsqu'un taux de variation instantané est supérieur au taux de variation moyen.

5. Actionneur de soupape selon la revendication 1 ou 2, dans lequel le dispositif de mesure (400) comprend : la répétition des fonctions du dispositif de mesure (400) une pluralité de fois et la prise en considération du résultat de mesure en tant que paramètre caractéristique de la soupape lorsque les résultats de la pluralité de fois de mesure au moyen du dispositif de mesure (400) sont cohérents.
